**Europäisches Patentamt**

(19) **European Patent Office**

**Office européen des brevets**

(11) Publication number : **0 471 399 B1**

## (12) EUROPEAN PATENT SPECIFICATION

(45) Date of publication of patent specification :
24.05.95 Bulletin 95/21

(51) Int. Cl.⁶ : **G01R 31/28**

(21) Application number : **91201949.4**

(22) Date of filing : **25.07.91**

(54) **Device for monitoring the supply voltage on integrated circuits.**

(30) Priority : **15.08.90 SE 9002665**

(43) Date of publication of application :
**19.02.92 Bulletin 92/08**

(45) Publication of the grant of the patent :
**24.05.95 Bulletin 95/21**

(84) Designated Contracting States :
**DE GB NL**

(56) References cited :
**EP-A- 0 358 376
US-A- 4 860 288
US-A- 4 872 169
US-A- 4 875 003
US-A- 4 879 717
Electronic design, 38 (1990-05): 10 Milton Ellis
JR et al: Botton-up techniques propel board
testability, page 57-page 64**

(56) References cited :
**Electronic Engeneering; 61 ( 1989-11 ): 755
Peter Hansen: Srategies for testing vlsi
boards using boundary scan page 103-page
111
Research disclosure april 1987, 27681 circuit
board tester
Research disclosure may 1989 , 30151 self test
method for secure Issd chip.
IBM Technical Disclosure Bulletin, 32 ( 1989-11
): 6AIBM CORP.: Ellimination of bus conten-
tion during chip-to-chip connectivity test, page
23-page 24**

(73) Proprietor : **TELEFONAKTIEBOLAGET L M
ERICSSON
Patent and Trademark Department
S-126 25 Stockholm (SE)**

(72) Inventor : **Haulin, Tord
Hammarbygatan 52
S-753 24 Uppsala (SE)**

(74) Representative : **Hopfgarten, Nils et al
Bergenstrahle & Lindvall AB
Box 17704
S-118 93 Stockholm (SE)**

EP 0 471 399 B1

## Description

The present invention relates to a device for monitoring locally the supply voltage on an integrated circuit (IC) after mounting on a circuit board, including at least one voltage monitor and boundary scan means for reading out the result of monitoring.

Integrated circuits of today require more and more parallel supply voltage connections for maintaining sufficient supply voltage, in spite of the high transient currents typical for rapid CMOS circuits. In component testing there is the possibility of checking, via special fixture configurations, that every one of the voltage and ground connections are intact. This possibility is lacking on circuit board. In addition there is the problem of checking that the de-coupling capacitors included in the circuits have been correctly connected.

There are no particularly suitable methods today for checking the supply distribution networks when testing boards. If a considerable part of the supply network fails, e.g. an interruption in one of two parallel soldered connections, it is possible for malfunction to occur when the board is tested. The latter can then be taken out for a (troublesome) fault finding procedure and repair. However, there is great risk that the fault does not show during board testing, and "merely" leads to deteriorated noise margins, especially with many parallell supply pins. This later leads to intermittent faults and poor reliability in the system.

For checking purposes it is already known to compare voltages at different places on a chip and read out the result via so-called boundary scanning, cf Electronic Design News, March 2, 1990, pp 127-130. This technique requires considerable wiring, however, and relies on resistance differences in board and circuit, in copper and aluminium, respectively. Dual sensors must be used here to guard against a break in any one of the supply pins. In addition, mean value formation and handling of small voltages are also required.

In the article "Bottom-Up Techniques Propel Board Testability", Electronic Design, vol. 38, No. 10, 24 May 1990, the concept of boundary scan is generally described as based on the JTAG standard (IEEE 1149.1). The built-in scan means allow a serial read-out of testing values at different places of an integrated circuit or regions of a circuit pattern board. An example of possible tests is testing the interconnection wiring between chips provided with this kind of boundary scan means and also "several test design, debugging, and integration schemes" can be performed by means of the boundary scan means.

The object of the present invention is to provide an improved possibility of monitoring voltage distribution systems on circuit boards and achieve a comparatively simple and cheap device for locally monitoring integrated circuit supply voltages after mounting on a circuit board, such as to give more distinct indication of the state of the distribution system, and enable checking where it is really required on the circuit board by local monitoring of the directly relevant magnitude, namely the instant supply voltage.

This object is achieved with a device of the kind mentioned in the introduction and provided with the characterising features disclosed in claim 1.

By building in supply voltage monitoring logic at suitable places on the circuit surface, in accordance with the invention, the quality of the supply voltage can be checked where this is really needed during board testing. Deficiencies in the voltage distribution lead to increased supply voltage ripple in the circuits. Monitoring can therefore be carried out to advantage with the aid of an extreme value detector, suitably implemented as a minimum value detector. In this way the deficiencies in the voltage feed distribution system are detected in circuits which can cause deteriorated function.

In the invention, extreme value measurement takes place with more distinct indication as a result, i.e. the directly relevant quantity is registered, namely the instant supply voltage, as mentioned above.

Supply voltage distribution on a circuit board can thus be functionally checked with the aid of the present invention. The added complexity of the circuit is then moderate. The technique is in line with other test logic, i.e. boundary scan. Interruption in one or more of a plurality of parallel voltage supply pins, or interruption in decoupling capacitors is detected if either leads to injurious supply voltage ripple. By varying the activity, e.g. by supplying test signals of different magnitudes and configuration to the circuit and voltage supply to the circuit board, it can be arranged to have an "alarm" solely from the one of the monitors included in the testing equipment, which monitor is situated where the supply voltage is worst of all. This facilitates faultfinding on the circuit board. The voltage supply monitors are also easy to test during component testing.

According to an advantageous further development of the device according to the invention, a comparator is adapted to compare the voltage value sensed by the detector with a predetermined, fixed or variable voltage value, and boundary scan means is disposed for reading out the result of the comparison. The reference voltage value will thus serve as an "alarm" level. A fault in the voltage distribution can be localised by variation of the reference value.

The voltage monitor comprises a D/A-converter and a comparator. During the test, especially for diagnosis, where a higher resolution is desired, several successive approximations are performed. The result will be an A/D-conversion of the peak voltage value. Thus the voltage monitor can be considered as a part of an A/D-converter where the operator provides the logic for the successive approximation.

The comparator is most simply realized with an inverter having a suitable triggering point. The decision point "alarm triggered" will be somewhat process-dependent in this case. If this is not desirable, a differential comparator can be used in stead in a still further embodiment of the device in accordance with the invention. In addition to these two possibilities of realizing the comparator, where they may be regarded as being two extreme ambition levels, it can also be advantageous to use a differential comparator with a voltage divider as the reference level.

In accordance with a still further embodiment of the device in accordance with the invention, the supply voltage monitor may be placed in the vicinity of circuit blocks having large current consumption in a functional strategy. However, for diagnosis it is better, in accordance with another advantageaus embodiment of the device in accordance with the invention, to dispose the voltage monitor at the voltage supply pins where voltage is comparatively stable when soldering is correct. For large chips with many closely placed pins a few monitors per voltage and chip side may be sufficient.

According to yet another advantageous embodiment of the device in accordance with the invention, the voltage monitor is disposed for activation simultaneously as a suitable test pattern is executed during a given time, the monitor registering the lowest instant supply voltage. The test pattern must be operated for a time of given duration, since boundary scan does not allow continuous parallel access.

Embodiments of the device in accordance with the invention, selected as examples, will now be described in more detail and with reference to the accompanying drawings, where Figure 1 is a block diagram of the device according to the invention, Figure 2 illustrates two complementary embodiments of the minimum value detector in the device according to the invention, Figure 3 illustrates the function and use of the minimum value detector, in two complementary embodiments, Figure 4 illustrates a practical embodiment of the minimum value detector of the device according to the invention, and Figure 5 illustrates a part of status diagram for the so-called boundary scan test access port controller in the device according to the invention.

The device in accordance with the invention includes a voltage monitor together with boundary scan for reading out the test results of the kind described in IEE Standard P1149.1 IEE Standard Test Access Port and Boundary Scan Architecture.

The voltage monitor includes a peak or extreme value detector 2, which is adapted to sense the instant supply voltage locally on its circuit surface, where voltage monitoring is desired. The characteristics of the detector, especially the sensitivity in voltage and time, i.e. how narrow and deep voltage peaks needed for the detector to react, can be varied by choosing different arrangements of transistors, diods and condensors.

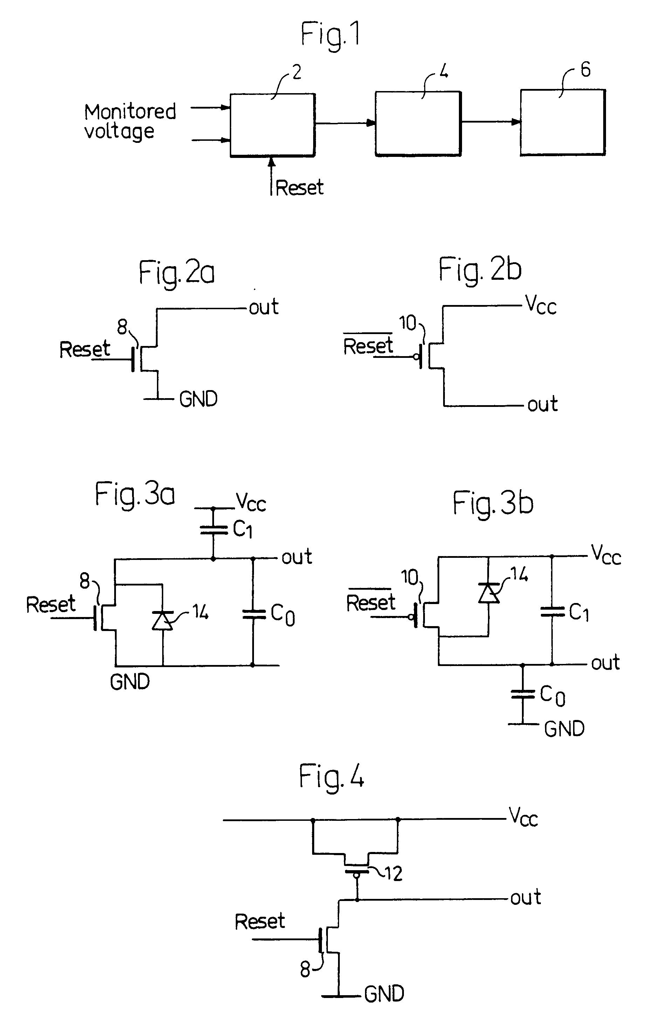

The sensed voltage value is compared in a comparator 4 with a fixed or variable reference value, and the result is stored in a boundary scan cell 6 with readout logic for shifting out the result according to the boundary scan concept, see Figure 1.

The reference level of the comparator 4 may be fixed or can be regulated. The reference value can be regulated for localising faults in the supply voltage distribution system. The reference level, which is accordingly the boundary for approval of the supply voltage, is also suitably implemented as an alarm level.

In using the device according to the invention the voltage monitor is activated simultaneously as a suitable test pattern is executed for a time of suitable duration, since boundary scan does not permit continuous parallel access. During this time the monitor suitably registers the lowest instant value of the supply voltage, i.e. the peak or extreme value detector 2 is implemented as a minimum value detector, as already mentioned.

The minimum value detector 2 may be implemented in several ways as mentioned above, and in Figures 2a and 2b there are illustrated two complementary embodiments including a transistor 8 and 10, respectively.

In Figures 3a and 3b there is illustrated the function and use of the detectors in Figures 2a and 2b. The capacitance $C_1$ between $V_{cc}$ and the output "out" is here arranged to dominate over the parasite capacitance $C_0$.

In Figure 4 there is illustrated a practical embodiment of a detector of the type illustrated in Figure 2a. As mentioned, the detector of Figure 2b has a complementary function with respect to logical levels.

The detector of Figure 4 includes, except for the transistor 8, a second transistor 12, connected between $V_{cc}$ and the output "out", as illustrated in the Figure. The detector functions as follows:

Before the start of the measuring period, the reset signal is activated, and the signal "out" then assumes the voltage GND, i.e. ground potential. The measuring period begins when the reset signal is deactivated. The voltage at the node "out" will now be dependent on the supply voltage according to the following relation:

$$V_{out} = V_{out\ reset} + V_{cc} \cdot \frac{C_1}{C_1 + C_0}$$

If $V_{cc}$ decreases, $V_{out}$ will be negative, since $V_{out\ reset}$ is equal to zero. However, $V_{out}$ cannot become particularly negative before clamping takes place. Depending on the technology used, either the parasite diode 14 or the transistor 8, or both are activated at $V_{clamp}$ (-1 V - 0,5 V), see Figure 3a.

A further decrease of $V_{cc}$ then discharges the capacitor $C_1$. When $V_{cc}$ regains its nominal voltage the

relation becomes:

$$V_{out} = V_{clamp} + (V_{ccnom} - V_{ccmin}) \cdot \frac{C_1}{C_1 + C_0}$$

This voltage is checked in the following threshold comparator 4.

The comparator 4 may be realised in several different ways. It is implemented most simply as an inverter with a suitable triggering point. Only two transistors are needed for this. The decision point will be somewhat process-dependent, however. If this is not desirable a differential comparator with MOS-transistors may be used. Also the use of bipolar transistors will can be considered. A reference voltage and eight to ten transistors are needed to implement such a comparator. The reference voltage can be taken into the circuit from the board, or generated on the chip, using a voltage divider, or in a boundary scan-controlled D/A-converter with two to three bit resolution on the chip. The comparator can be implemented for latching, if so desired.

An ordinary boundary scan cell 6 is required, which is described in the above-mentioned publication IEEE Standard B1149.1 IEEE Standard Test Access Port and Boundary-Scan Archtecture. Output multiplexors are not needed, since this link does not handle system data.

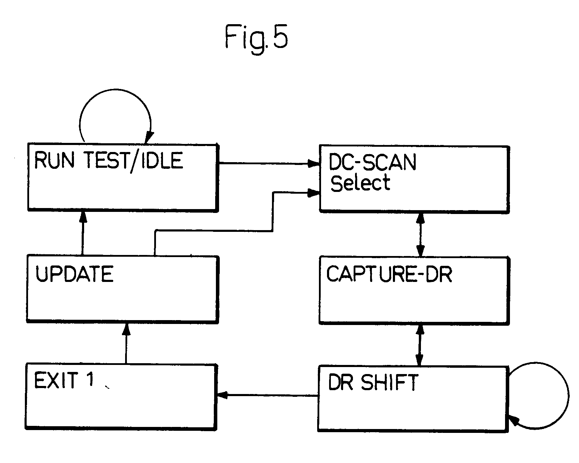

In Figure 5 there is illustrated a part of the status diagram for the boundary scan test access port controller (TAP).

The reset signal for the voltage monitors is generated when the TAP controlled is in the state UPDATE. A suitable signal for reset (HOLDZ) is already generated and distributed to the boundary scan carrier of today.

The supply voltage test starts when UPDATE is delivered, and is terminated at CAPTURE when the comparator signal is clocked into the boundary scan flipflop. The result of the test is shifted out from the boundary scan cells in the state DR SHIFT.

The activity level of the circuit during the test is determined by which test instruction has been put in. If one of the background test instructions is selected, the circuit carries out its normal function during the entire test. If a test mode function is put in, the activity may be varied from "Everything stopped except test access port controller". With the use of a toggle instruction there is achieved very great activity.

In this way a good picture of the supply voltage ripple can be obtained. In order to further increase resolution and diagnosis possibilities the circuit board supply voltage may be varied during the test. This can be essential for exact indication of a faulty pin for its repair, as mentioned above.

During component testing the supply voltage monitors may be functionally checked with the supply voltage test by maintaining nominal voltage to the circuit in a first test and subsequently lowering the voltage to the circuit during a second test.

In an alternative embodiment of the device according to the invention the voltage monitor is provided to first compare the instant value of the supply voltage with the reference value. The memory function needed for the peak value detection is realized by a locking flipflop with a reset input. The flipflop is connected to the ouput of the comparator. An exact adjustment by manipulating the supply voltage during different phases of the test is the impossible. Therefore a D/A-converter is needed for this adjustment. In this embodiment a very fast comparator must be used.

## Claims

1. A device for monitoring locally the supply voltage on an integrated circuit (IC) after mounting on a circuit board having a plurality of parallel voltage supply pins, the device including at least one voltage monitor and boundary scan means for reading out the result of monitoring, **characterised in** that the voltage monitor includes an extreme value detector (2) disposed at the place on the circuit surface where voltage monitoring is desired, and that a comparator (4) is adapted to compare the voltage value sensed by the detector (2) with a predetermined, fixed or variable voltage value, and in that the boundary scan means (6) is arranged for reading out the result of the comparison.

2. The device of claim 1, **characterized in** that the extreme value detector (2) is adapted to sense the instant minimum value.

3. The device of claim 1 or 2, **characterized in** that a boundary scan controlled D/A-converter is disposed on the circuit chip for generating the comparator's reference voltage.

4. The device of any one of claims 1 - 3, **characterized in** that the comparator (4) is implemented as an inverter having a suitable triggering point.

5. The device of any one of claims 1 - 3, **characterized in** that the comparator (4) is a differential comparator.

6. The device of any one of claims 1 - 5, **characterized in** that the voltage monitor is placed in the vicinity of circuit blocks having high current consumption.

7. The device of any one of claims 1 - 5, **characterized in** that the voltage monitor is disposed at the circuit's supply voltage pins.

8. The device of any one of claims 1 - 7, **characterized in** that the voltage monitor is adapted for activation simultaneously as a suitable test pattern is carried out during a given time, the monitor then registering the lowest instant supply voltage.

9. The device of any one of claims 1 - 8, **characterized in** that a plurality of voltage monitors with associated boundary scan means is arranged at a plurality of places on the circuit surface where voltage monitoring is desired.

**Patentansprüche**

1. Vorrichtung zum lokalen Überwachen der Speisespannung an einer integrierten Schaltung (IC) nach dem Anbringen an einer Leiterplatte mit einer Vielzahl paralleler Spannungszufuhrstifte, wobei die Vorrichtung wenigstens eine Spannungsüberwachungseinrichtung und eine Grenzwertabtasteinrichtung zur Ausgabe des Ergebnisses der Überwachung enthält, **dadurch gekennzeichnet,** daß die Spannungsüberwachungseinrichtung einen Extremwertdetektor (2) enthält, der an der Stelle auf der Schaltungsoberfläche angeordnet ist, an der die Spannung überwacht werden soll, und daß ein Komparator (4) den durch den Detektor (2) erfaßten Spannungswert mit einem vorgegebenen, festen oder veränderlichen Spannungswert vergleicht, und daß die Grenzwertabtasteinrichtung (6) das Ergebnis des Vergleichs ausgibt.

2. Vorrichtung nach Anspruch 1, **dadurch gekennzeichnet,** daß der Extremwertdetektor (2) den momentanen Minimalwert erfaßt.

3. Vorrichtung nach Anspruch 1 oder 2, **dadurch gekennzeichnet,** daß ein grenzwertabtastgesteuerter D/A-Wandler auf dem Schaltungschip angebracht ist, der die Bezugsspannung des Komparators erzeugt.

4. Vorrichtung nach einem der Ansprüche 1 - 3, **dadurch gekennzeichnet**, daß der Komparator (4) als eine Umkehrstufe mit einem geeigneten Triggerpunkt ausgeführt ist.

5. Vorrichtung nach einem der Ansprüche 1 - 3, **dadurch gekennzeichnet**, daß der Komparator (4) ein Differentialkomparator ist.

6. Vorrichtung nach einem der Ansprüche 1 - 5, **dadurch gekennzeichnet**, daß die Spannungsüberwachungseinrichtung in der Nähe von Schaltungsblöcken mit hohem Stromverbrauch angebracht ist.

7. Vorrichtung nach einem der Ansprüche 1 - 5, **dadurch gekennzeichnet**, daß die Spannungsüberwachungseinrichtung an den Speisespannungsstiften der Schaltung angeordnet ist.

8. Vorrichtung nach einem der Ansprüche 1 - 7, **dadurch gekennzeichnet**, daß die Spannungsüberwachungseinrichtung aktiviert wird, während gleichzeitig während eines vorgegebenen Zeitraums ein geeignetes Testmuster ausgeführt wird, wobei die Übewachungseinrichtung dann die niedrigste momentane Speisespannung registriert.

9. Vorrichtung nach einem der Ansprüche 1 - 8, **dadurch gekennzeichnet**, daß eine Vielzahl von Spannungsüberwachungseinrichtungen mit dazugehörigen Grenzwertabtasteinrichtungen an einer Vielzahl von Stellen auf der Schaltungsoberfläche angeordnet sind, an denen die Spannung überwacht werden soll.

**Revendications**

1. Dispositif pour surveiller localement la tension d'alimentation sur un circuit intégré après montage sur une carte à circuit imprimé ayant une pluralité de broches d'alimentation en tension, le dispositif comprenant au moins un circuit de surveillance de tension et des moyens de balayage à limites pour indiquer le résultat de la surveillance, caractérisé en ce que le circuit de surveillance de tension comprend un détecteur de valeur extrême (2) disposé à l'endroit de la surface du circuit où la surveillance de la tension est désirée; en ce qu'un comparateur (4) est adapté pour comparer la valeur de tension détectée par le détecteur (2) à une valeur de tension prédéterminée fixe ou variable; et en ce que les moyens de balayage à limites (6) sont agencés pour indiquer le résultat de la comparaison.

2. Dispositif selon la revendication 1, caractérisé en ce que le détecteur de valeur extrême (2) est adapté pour détecter la valeur minimale instantanée.

3. Dispositif selon la revendication 1 ou 2, caractérisé en ce qu'un convertisseur numérique/analogique commandé par le balayage à limites est disposé sur la puce de circuit intégré pour produire la tension de référence du comparateur.

4. Dispositif selon l'une quelconque des revendications 1 à 3, caractérisé en ce que le comparateur (4) est réalisé sous la forme d'un inverseur ayant un point de déclenchement convenable.

5. Dispositif selon l'une quelconque des revendications 1 à 3, caractérisé en ce que le comparateur (4) est un comparateur différentiel.

6. Dispositif selon l'une quelconque des revendications 1 à 5, caractérisé en ce que le circuit de surveillance de tension est placé à proximité de blocs de circuits ayant une grande consommation de courant.

7. Dispositif selon l'une quelconque des revendications 1 à 5, caractérisé en ce que le circuit de surveillance de tension est disposé au niveau des broches de tension d'alimentation du circuit.

8. Dispositif selon l'une quelconque des revendications 1 à 7, caractérisé en ce que le circuit de surveillance de tension est adapté pour être activé en même temps qu'un programme de test convenable est exécuté pendant un temps donné, le circuit de surveillance enregistrant alors la tension d'alimentation instantanée la plus basse.

9. Dispositif selon l'une quelconque des revendications 1 à 8, caractérisé en ce qu'une pluralité de circuits de surveillance de tension avec des moyens de balayage à limites sont agencés à une pluralité d'endroits, sur la surface du circuit, où la surveillance de tension est désirée.

## Fig.1

Monitored voltage → [2] → [4] → [6]
Reset

## Fig.2a

Reset [8] out / GND

## Fig. 2b

$\overline{Reset}$ [10] Vcc / out

## Fig.3a

Vcc, $C_1$, out, Reset [8], [14], $C_0$, GND

## Fig.3b

$\overline{Reset}$ [10], [14], Vcc, $C_1$, out, $C_0$, GND

## Fig. 4

Vcc, [12], out, Reset, [8], GND

## Fig.5